# EUROPEAN PATENT APPLICATION

(11) **EP 4 404 285 A2**
(43) Date of publication of application: **24.07.2024**
(21) Application number: 24178384.4
(22) Date of filing: 28.05.2024
(51) Int. Cl.: H01L 31/18, H01B 13/00, H01L 31/0224

(54) **TRANSFER PRINTING ASSEMBLY, SOLAR CELL, AND PREPARATION METHOD THEREOF**

(30) Priority: 23.11.2023 CN 202311577226
(71) Applicant: Trina Solar Co., Ltd., Changzhou, Jiangsu Province 213031 (CN)
(72) Inventor: YANG, Guangtao, CHANGZHOU, 213031 (CN); CHEN, Daming, CHANGZHOU, 213031 (CN); CHEN, Yifeng, CHANGZHOU, 213031 (CN)
(74) Representative: Arnold & Siedsma

(57) **Abstract**

The present application relates to a transfer printing assembly, a solar cell, and a preparation method thereof. The transfer printing assembly (10) includes a carrier (11) and a first conducting wire (12). The carrier (11) includes a first surface having a first groove. The first conducting wire (12) is at least partially disposed within the first groove. The first conducting wire and a wall of the first groove define a first receiving cavity at a side of the first conducting wire adjacent to an opening of the first groove. The first receiving cavity is configured to accommodate slurry material. The first conducting wire is detachable from the first groove under an action of external energy.

## Description

### CROSS-REFERENCE TO RELATED APPLICATION

This application claims priority to Chinese patent application No. 202311577226.3, filed on November 23, 2023, and titled "TRANSFER PRINTING ASSEMBLY, SOLAR CELL, AND PREPARATION METHOD THEREOF", the content of which is hereby incorporated herein in its entirety by reference.

### TECHNICAL FIELD

The present application relates to the technical field of photovoltaic solar cells, specifically to transfer printing assemblies, solar cells, and preparation methods thereof.

### BACKGROUND

Confronted with the critical challenge of non-renewable energy resources dwindling globally, many countries are actively advocating and promoting renewable and clean energies. In light of these efforts, the photovoltaic industry, which specializes in transforming solar energy into electrical power, has received unprecedented opportunities for development.

In the existing production techniques for silicon solar cells, the formation of electrode metal lines primarily relies on screen printing or electroplating methods. However, forming electrode lines narrower than 25µm using the screen printing technique poses significant challenges, and the costs associated with electroplating are relatively high.

### SUMMARY

In view of the above, there is a need to provide a transfer printing assembly, a solar cell, and a preparation method thereof.

A first aspect of the present application provides a transfer printing assembly including a carrier and a first conducting wire.

The carrier includes a first surface having a first groove.

The first conducting wire is at least partially disposed within the first groove; the first conducting wire and a wall of the first groove define a first receiving cavity at a side of the first conducting wire adjacent to an opening of the first groove; the first receiving cavity is configured to accommodate slurry material.

The first conducting wire is detachable from the first groove under an action of external energy.

The transfer printing assembly provided in embodiments of the present application is configured for transferring materials and thereby forming electrode lines. On the one hand, compared to the electroplating method, using the transfer printing assembly is conducive to reducing the manufacturing costs; on the other hand, compared to the screen printing method, the width of the electrode lines can be controlled by containing the slurry material in the groove, thereby facilitating formation of the electrode lines with a relatively small width. In addition, by arranging the first conducting wire in the groove, the wastage of the slurry material can be reduced.

In some embodiments, the entirety of the first conducting wire is located in the first groove.

In some embodiments, the first conducting wire partially protrudes out from the opening of the first groove, a cross-section of the first conducting wire has an end that is located away from the first groove, and a distance between the end of the cross-section and the opening of the first groove is greater than 0µm and less than or equal to 200µm.

In some embodiments, the carrier includes a second surface opposite to the first surface; a peripheral surface of the first conducting wire includes an inner portion that is adjacent to the second surface, and the inner portion is in contact with a portion of the wall of the first groove; a size of the first conducting wire along a first direction is less than or equal to a size of the first groove along the first direction, and the first direction is from the first surface to the second surface.

In some embodiments, the peripheral surface of the first conducting wire includes an outer portion that is away from the second surface, the minimum distance between the outer portion and the opening of the first groove is in a range from 0 to 200µm.

In some embodiments, 0.25L₁≤L₂≤L₁, wherein L₁ is the maximum distance between the outer portion and the opening of the first groove, and L₂ is the minimum distance between the outer portion and the opening of the first groove.

In some embodiments, a size of the opening of the first groove along a second direction is greater than or equal to a size of the first conducting wire along the second direction, and the second direction is perpendicular to the first direction.

In some embodiments, a size of the first conducting wire along the first direction ranges from 1 µm to 220µm.

In some embodiments, a size of the first conducting wire along the second direction ranges from 5µm to 220µm.

In some embodiments, the first surface of the carrier has a plurality of first grooves spaced apart along the second direction, and the transfer printing assembly includes a plurality of first conducting wires spaced apart along the second direction; the plurality of first grooves and the plurality of first conducting wires all extend along a third direction, and the third direction intersects with the second direction; the plurality of first conducting wires are at least partially disposed within the plurality of first grooves in a one-to-one correspondence.

In some embodiments, a first distance between any two adjacent first conducting wires ranges from 200µm to 2000µm.

In some embodiments, the first conducting wire includes a main section and a widened section, and a size of the widened section along the second direction is greater than that of the main section along the second direction.

In some embodiments, the carrier includes a central area and edge areas, and the edge areas are located at opposite sides of the central area along the second direction; the plurality of first grooves include edge grooves and central grooves, the plurality of first conducting wires include edge conducting wires and central conducting wires; the edge grooves and the edge conducting wires therein are distributed in the edge areas, and the central grooves and the central conducting wires therein are distributed in the central area.

In some embodiments, the edge areas include at least one avoidance area, the avoidance area spans across at least two edge grooves and at least two edge conducting wires therein, separating the at least two edge grooves each into at least two sub-grooves spaced apart from each other, and separating the at least two edge conducting wires each into at least two sub-wires spaced apart from each other.

In some embodiments, the transfer printing assembly further includes a connection conducting wire, and the first surface of the carrier further has a connection groove, the connection conducting wire is at least partially disposed within the connection groove; the connection groove and the connection conducting wire therein extend along an edge of the avoidance area; the connection groove is in communication with same sided sub-grooves of the at least two edge grooves, and the connection conducting wire is connected to same sided sub-wires of the at least two edge conducting wires; the connection conducting wire and a wall of the connection groove define a connection receiving cavity at a side of the connection conducting wire adjacent to an opening of the connection groove; the connection receiving cavity is configured to accommodate the slurry material; the connection conducting wire is detachable from the connection groove under an action of external energy.

In some embodiments, the first conducting wire includes an electrically conductive core and an anti-oxidation layer surrounding the core, and the material of the anti-oxidation layer includes metal.

In some embodiments, the material of the conductive core includes copper or aluminum.

In some embodiments, the material of the anti-oxidation layer includes at least one of silver, tin, lead, titanium, or nickel.

In some embodiments, the carrier is a flexible member.

In some embodiments, the first surface of the carrier has a second groove intersecting with the first groove; the transfer printing assembly further includes a second conducting wire intersecting with the first conducting wire; the second conducting wire is at least partially disposed within the second groove; the second conducting wire and a wall of the second groove define a second receiving cavity at a side of the second conducting wire adjacent to an opening of the second groove; the second receiving cavity is configured to accommodate the slurry material; the second conducting wire is detachable from the second groove under an action of external energy.

A second aspect of the present application provides a solar cell including a cell body and first electrode lines. The cell body includes a first face and a second face opposite to each other. The first electrode lines are disposed on both the first and second faces and spaced apart from each other. Each first electrode line includes a first metal layer and the first conducting wire stacked on the first metal layer, the first metal layer is connected to the cell body.

The electrode lines of the solar cell provided in embodiments of present application can be formed by using the transfer printing assembly. On the one hand, compared with the electroplating method, using the transfer printing assembly to form the electrode lines is conducive to reducing the manufacturing costs. On the other hand, compared with the screen printing method, the width of the electrode lines can be controlled by containing the slurry material in the groove, thereby facilitating formation of the electrode lines with a relatively small width. In addition, by arranging the first conducting wire in the groove, the wastage of the slurry material can be reduced.

In some embodiments, an orthogonal projection of the first conducting wire on the cell body falls within an orthogonal projection of the first metal layer on the cell body.

In some embodiments, on a same side of the cell body, two adjacent first electrode lines are spaced apart by a first distance, and the first distance ranges from 200µm to 2000µm.

In some embodiments, the minimum distance from the first electrode lines to an edge of the cell body ranges from 50µm to 1500µm.

In some embodiments, the first electrode lines each include a main portion and a widened portion, and a width of the widened portion is greater than that of the main section.

In some embodiments, the cell body includes a central region and edge regions, and the edge regions are located at opposite sides of the central region; the first electrode lines include edge electrode lines and central electrode lines; the edge electrode lines are distributed on the edge regions, and the central electrode lines are distributed on the central region.

In some embodiments, the edge regions include at least one avoidance region, the avoidance region spans across at least two edge electrode lines, separating the at least two edge electrode lines each into at least two sub-electrode lines spaced apart from each other.

In some embodiments, the solar cell further includes second electrode lines, the second electrode lines are disposed on at least one of the first and second faces and electrically connected to the first electrode lines.

In some embodiments, an orthogonal projection of the second electrode lines on the cell body has an overlapping area with an orthogonal projection of the widened portion of the first electrode lines on the cell body; or a portion of the orthogonal projection of the second electrode lines falls within the avoidance region.

In some embodiments, the cell body includes a first transparent conducting layer, a first doped layer, a first intrinsic semiconductor layer, a silicon substrate, a second intrinsic semiconductor layer, a second doped layer, and a second transparent conducting layer stacked in sequence. The first face is located at a side of the first transparent conducting layer away from the silicon substrate, and the second face is located at a side of the second transparent conducting layer away from the silicon substrate.

A third aspect of the present application provides a method for preparing a solar cell, including:
providing a cell body and a transfer printing assembly as described in any embodiment of the first aspect;
filling the first receiving cavity of the transfer printing assembly with slurry material;
placing the transfer printing assembly onto a surface of the cell body for transfer printing and applying energy to the transfer printing assembly to transfer the first conducting wire and the slurry material onto the surface of the cell body; and
solidifying the slurry material on the cell body.

The preparation method of the solar cell in embodiments of the present application involves transfer printing to form electrode lines. On the one hand, compared with the electroplating method, using the transfer printing assembly is conducive to reducing the manufacturing costs; on the other hand, compared with the screen printing method, the width of the electrode lines can be controlled by containing the slurry material in the groove, thereby facilitating formation of the electrode lines with a relatively small width. In addition, by arranging the first conducting wire in the groove, the wastage of the slurry material can be reduced.

### BRIEF DESCRIPTION OF THE DRAWINGS

In order to more clearly describe the embodiments or examples of the present application, the accompanying drawings to be used in the description of the embodiments or examples will be described briefly. Obviously, the drawings described below are only for some embodiments of the present application. For ordinary skilled persons in the art, other drawings can also be obtained based on the following drawings without creative works.
FIG. 1 is a schematic sectional view of a transfer printing assembly according to an embodiment of the present application.
FIG. 2 is a schematic cross-sectional view of the transfer printing assembly shown in FIG. 1 loaded with slurry material.
FIG. 3 is a schematic view of transfer printing using the transfer printing assembly shown in FIG. 1.
FIG. 4 is a schematic cross-sectional view of a transfer printing assembly according to another embodiment of the present application.
FIG. 5 is a schematic cross-sectional view of a transfer printing assembly according to yet another embodiment of the present application.
FIG. 6 is a schematic cross-sectional view of a transfer printing assembly according to yet another embodiment of the present application.
FIG. 7 is a schematic bottom view of the transfer printing assembly shown in FIG. 6.
FIG. 8 is a schematic bottom view of a transfer printing assembly according to another embodiment of the present application.
FIG. 9 is a schematic cross-sectional partial view of a solar cell according to an embodiment of the present application.
FIG. 10 is a schematic top view of a solar cell according to an embodiment of the present application.
FIG. 11 is a schematic structural view of region I in FIG. 10 according to an embodiment of the present application.
FIG. 12 is a schematic structural view of region I in FIG. 10 according to another embodiment of the present application.
FIG. 13 is a schematic cross-sectional view of a solar cell according to another embodiment of the present application.
FIG. 14 shows a flowchart of a method for preparing a solar cell according to an embodiment of the present application.
FIG. 15 is a schematic view of the method shown in FIG. 14.
FIG. 16 is a schematic bottom partial view of a transfer printing assembly according to an embodiment of the present application.

### Reference Signs:

10, transfer printing assembly; 11, carrier; 111, avoidance area; 11a, first groove; 11a1, sub-groove; 11a2, connection groove; 11b, first receiving cavity; 11c, second groove; 111, first surface; 112, second surface; 12, first conducting wire; 12a, sub-wire; 12b, connection conducting wire; 121, electrically conductive core; 122, anti-oxidation layer; 13, second conducting wire;
20, solar cell; 21, cell body; 21a, first face; 21b, second face; 211, first transparent conducting layer; 212, first doped layer; 213, first intrinsic semiconductor layer; 214, silicon substrate; 215, second intrinsic semiconductor layer; 216, second doped layer; 217, second transparent conducting layer; 22, first electrode line; 221, first metal layer; 22a, main portion; 22b, widened portion; 22c, sub-electrode line; 22d, avoidance region; 22e, connection electrode line.

### DETAILED DESCRIPTION

The present application will now be described in detail with reference to the accompanying drawings in order to make the objects, features, and advantages of the present application clearer. In the following description, many specific details are explained to make the present application fully understandable. However, the present application can be implemented in many other ways different from those described herein, and those skilled in the art can make similar improvements without departing from the connotation of the present application. Therefore, the present application is not limited by the specific embodiments disclosed below.

Unless defined otherwise, all technical and scientific terms used herein have the same meaning as commonly understood by those skilled in the art of the present application. The terms used in the specification of the present application are for the purpose of describing exemplary examples only and are not intended to limit the present application.

It should be understood that when an element or a layer is referred to as being "on", "adjacent to", "connected to", or "coupled to" another element or layer, it can be directly on, adjacent to, connected to, or coupled to another element or layer, or an intermediate element or layer can be present. In contrast, when an element is referred to as being "directly on", "directly adjacent to", "directly connected to", or "directly coupled to" another element or layer, there is no intervening element or layer. It can be understood that although the terms first, second, third etc. may be used to describe various elements, components, regions, layers, sections, and/or doping types, these elements, components, regions, layers, sections, and/or doping types should not be limited by these terms. These terms are only used to distinguish one element, component, region, layer, section, and/or doping type from another element, component, region, layer, section, and/or doping type. Thus, a first element, component, region, layer, section, and/or doping type described below can be termed as a second element, component, region, layer, section, and/or doping type without departing from the teachings of the present application.

For the convenience of description, the spatial relation terms such as "below", "under", "beneath", "above", "on", "over", etc., may be used herein to describe the relationships of an element or a feature with other elements or features shown in the drawings. It should be understood that the terms of spatial relations are intended to include other different orientations in use or operation in addition to the orientation of the elements or features shown in the drawings. For example, if the drawings are placed upside down, the element or feature which was "above" or "over" other elements or features will be "below" or "under" other elements or features. Thus, the exemplary terms "below" and "beneath" may cover the meanings of "above" or "below". The element or feature can also be positioned in other different ways (e.g., rotating 90 degrees or at other orientations), and the spatial relation terms used herein can be correspondingly interpreted.

As used herein, the singular forms with "a", "an", "the", or "said" are intended to include the plural forms as well, unless the context clearly indicates otherwise. It should also be understood that the terms "consists of" and/or "comprising", when used in the present application, identify the presence of the stated features, integers, steps, operations, elements and/or parts, but do not exclude presence or addition of one or more other features, integers, steps, operations, elements, parts and/or groups. As used herein, the term "and/or" means that any one of the listed items can be employed by itself or any combination of two or more of the listed items can be employed.

The embodiments of the present application are described herein with reference to cross-sectional views of idealized embodiments (and intermediate structures) of the present application. It can be expected that some variations of the shown shapes may exist due to, for example, manufacturing techniques and/or engineering tolerances. Thus, embodiments of the present application should not be limited to the particular shapes of the regions shown herein but include deviations in shapes due to, for example, manufacturing. The regions shown in the drawings are schematic in nature, and their shapes are not intended to be the actual shapes of the regions of the device or limit the scope of the present application.

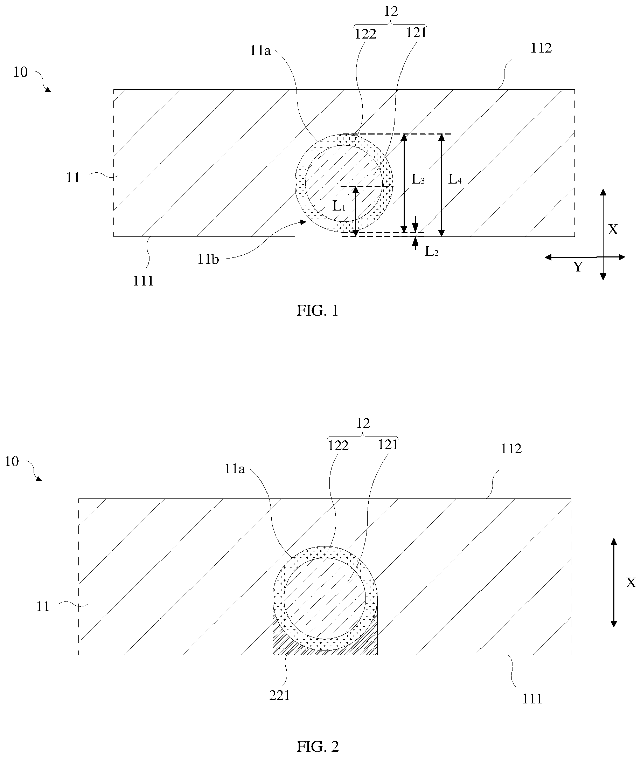

Referring to FIG. 1, a first aspect of the present application provides a transfer printing assembly 10, which is used in forming electrode lines of a solar cell 10. The transfer printing assembly 10 includes a carrier 11 and a first conducting wire 12. The carrier 11 includes a first surface 111 having a first groove 11a. The first conducting wire 12 is at least partially disposed within the first groove 11a. The first conducting wire 12 and a wall of the first groove 11a define a first receiving cavity 11b at a side of the first conducting wire 12 adjacent to an opening of the first groove 11a. That is, the first receiving cavity 11b is formed at the side of the first conducting wire 12 adjacent to the opening of the first groove 11a. The first receiving cavity 11b is configured to accommodate slurry material. The first conducting wire 12 is detachable from the first groove 11a under an action of external energy.

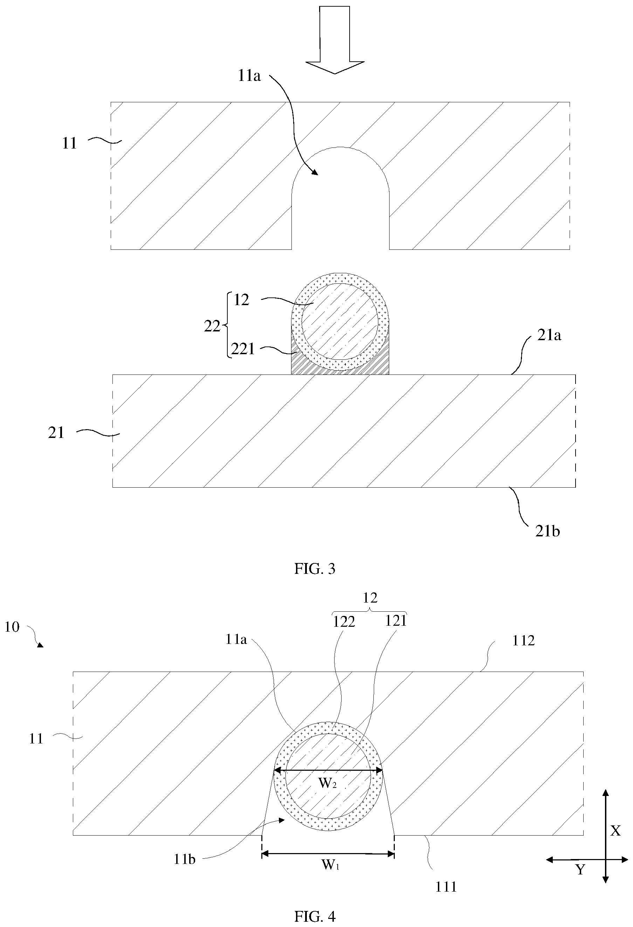

Referring to FIGs. 2 and 3, in the process of forming an electrode line, the first receiving cavity 11b is loaded with slurry material first, then the transfer printing assembly 10 is placed onto the cell body 21, with the opening of the first groove 11a facing a transfer printed surface of the cell body 21. External energy is then applied to the transfer printing assembly 10, for example, by irradiating the transfer printing assembly 10 with a laser. Under the action of the external energy, the first conducting wire 12 and the slurry material detach from the first groove 11a and come into contact with the transfer printed surface of the cell body 21. The transfer printed first conducting wire 12 and slurry material together form the electrode line, e.g., a first electrode line 22.

The first conducting wire 12 can be made of metal, which can be copper, aluminum, etc. In some embodiments, the first conducting wire 12 can be directly formed on a wall of the first groove 11a using a manufacturing process well known to those skilled in the art.

The transfer printing assembly 10 provided in the embodiments of the present application is configured for transferring materials and thereby forming electrode lines. On the one hand, compared with the electroplating method, using the transfer printing assembly 10 is conducive to reducing the manufacturing costs. On the other hand, compared with the screen printing method, the width of the electrode lines can be controlled by containing the slurry material in the groove, thereby facilitating formation of the electrode lines with a relatively small width. In addition, by arranging the first conducting wire 12 in the groove, the wastage of the slurry material can be reduced.

Referring to FIGs. 1 and 4, in some embodiments, the entirety of the first conducting wire 12 is located in the first groove 11a. In other words, the first conducting wire 12 does not protrude out from the opening of the first groove 11a. Thus, when applying the slurry material into the first receiving cavity 11b, the first conducting wire 12 does not interfere with the slurry applying equipment, reducing the difficulty of loading the slurry material.

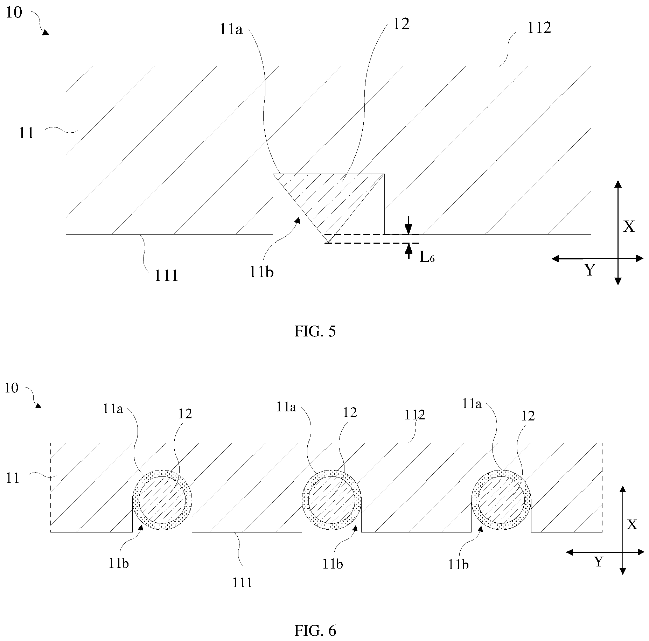

Referring to FIG. 5, in some embodiments, the first conducting wire 12 partially protrudes out from the opening of the first groove 11a. A cross-section of the first conducting wire 12 has an end that is away from the first groove 11a, and a distance L₆ between the end of the cross-section and the opening of the first groove 11a can be greater than 0µm and less than or equal to 200µm. In some embodiments, L₆ can be 1µm, 50µm, 80µm, 120µm, 160µm, 175µm, or 200µm.

In the above described embodiments, on the one hand, the volume of the first conducting wire 12 can be increased, reducing the required amount of the slurry material, thereby reducing costs; on the other hand, the ohmic contact between the electrode line and the cell body 21 can be ensured.

Referring to FIG. 1, in some embodiments, the carrier 11 includes a second surface 112 opposite to the first surface 111. The first groove 11a extends from the first surface 111 towards the interior of the carrier 11. A peripheral surface of the first conducting wire 12 includes an inner portion that is adjacent to the second surface 112, and the inner portion is in contact with and conformal with a portion of the wall, e.g., the bottom wall, of the first groove 11a. In other words, the inner portion is entirely in contact with the wall of the first groove 11a. A size L₃ of the first conducting wire 12 along a first direction X is less than or equal to a size L₄ of the first groove 11a along the first direction X, and the first direction X is defined as from the first surface 111 to the second surface 112. As shown in FIG. 1, the first direction X can be a thickness direction of the carrier 11, the size L₄ of the first groove 11a can be a depth of the first groove 11a, and the size L₃ of the first conducting wire 12 can be a diameter or thickness of the first conducting wire 12.

In the above described embodiments, the entire structure of the first conducting wire 12 is contained within the first groove 11a. Thus, when applying the slurry material into the first receiving cavity 11b, the first conducting wire 12 does not interfere with the slurry applying equipment, reducing the difficulty in applying the slurry material.

Referring to FIG. 1, in some embodiments, the peripheral surface of the first conducting wire 12 includes an outer portion that is away from the second surface 112. The minimum distance L₂ between the outer portion of the peripheral surface of the first conducting wire 12 and the opening of the first groove 11a can be in a range from 0 to 200µm. In some embodiments, L₂ can be 0µm, 50µm, 80µm, 100µm, 120µm, 160µm, 180µm, or 200µm.

In the above described embodiments, on the one hand, when applying the slurry material into the first receiving cavity 11b, the first conducting wire 12 does not interfere with the slurry applying equipment, reducing the difficulty of applying the slurry material; on the other hand, the volume of the first receiving cavity 11b can be reduced, reducing the required amount of the slurry material.

In some embodiments, 0.25L₁≤L₂≤L₁, where L₁ is the maximum distance between the outer portion of the peripheral surface of the first conducting wire 12 and the opening of the first groove 11a, and L₂ is the minimum distance between the outer portion of the peripheral surface of the first conducting wire 12 and the opening of the first groove 11a.

It can be understood that the smaller the difference between the minimum distance L₁ and the maximum distance L₂, the more uniform the slurry material in the first receiving cavity 11b, which means that the thickness of the slurry material in the first receiving cavity 11b is more uniform. This further improves the distribution uniformity of the slurry material between the first conducting wire 12 and the surface of the cell body 21 along the second direction Y. In this way, during the transfer printing of the electrode line, the bonding force between the first conducting wire 12 and the cell body 21 can be relatively uniform along the second direction Y, thereby improving the stability of the bonding between the electrode line and the cell body 21. Therefore, by satisfying the above relationship between L₂ and L₁, the stability of the bonding between the electrode line and the cell body 21 can be improved, and the required amount of the slurry material can be reduced.

Referring to FIGs. 1 and 4, in some embodiments, a size W₁ of the opening of the first groove 11a along a second direction Y is greater than or equal to a size W₂ of the first conducting wire 12 along the second direction Y. The second direction Y is perpendicular to the first direction X and the extending direction of the first groove 11a. The extending direction of the first groove 11a can be the length direction of the first groove 11a.

By satisfying the above relationship between W₂ and W₁, the first conducting wire 12 can be easily detached from the first groove 11a during the transfer printing of electrode line.

Referring to FIG. 1, in some embodiments, the size L₃ of the first conducting wire 12 along the first direction X ranges from 1µm to 220µm. The size L₃ can be the maximum size of the first conducting wire 12 along the first direction X. In some embodiments, L₃ can be 1µm, 10µm, 30µm, 50µm, 80µm, 110µm, 150µm, 175µm, 200µm, 210µm, or 220µm.

In the above described embodiments, on the one hand, the first conducting wire 12 has relatively large diameter or thickness, thereby enhancing the ability of the electrode line to collect current carriers; on the other hand, the required amount of the slurry material can be reduced, thereby reducing the costs.

Referring to FIG. 4, in some embodiments, the size W₂ of the first conducting wire 12 along the second direction Y ranges from 5 µm to 220µm. The size W₂ can be the maximum size of the first conducting wire 12 along the second direction Y. In some embodiments, W₂ can be 5µm, 15µm, 30µm, 45µm, 65µm, 80µm, 100µm, 130µm, 150µm, 180µm, 190µm, 205µm, or 220µm.

In the above described embodiments, with the current carrier collection ability of the electrode line ensured, the width of the electrode line can be within a reasonable range, reducing obstruction to sunlight irradiation.

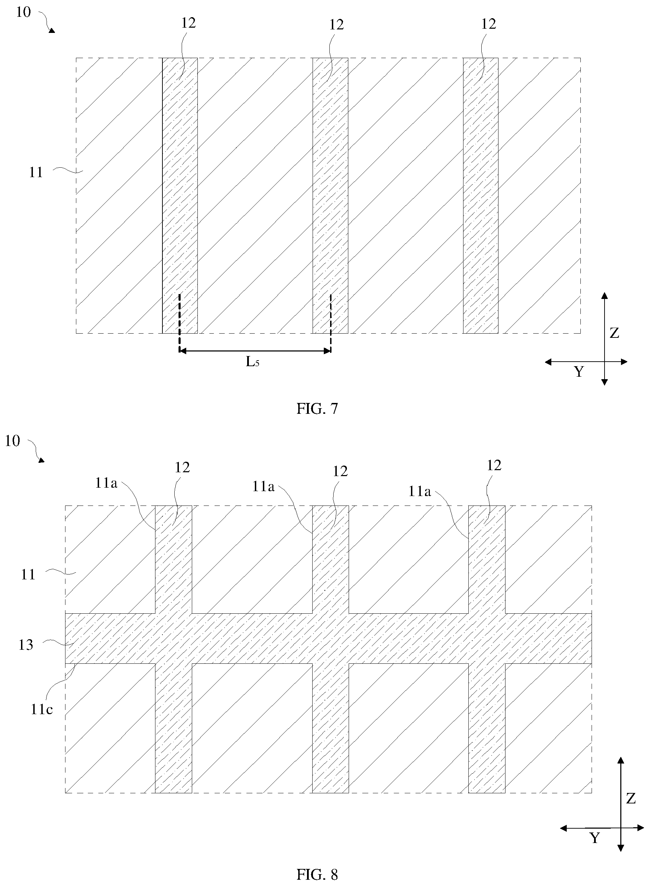

Referring to FIGs. 6 and 7, in some embodiments, the first surface 111 of the carrier 11 has a plurality of first grooves 11a spaced apart along the second direction Y. The transfer printing assembly 10 includes a plurality of first conducting wires 12 spaced apart along the second direction Y. The plurality of first grooves 11a and the plurality of first conducting wires 12 all extend along a third direction Z, and the third direction Z intersects with the second direction Y. The plurality of first conducting wires 12 are at least partially disposed within the plurality of first grooves 11a in a one-to-one correspondence.

In some embodiments, a first distance L₅ between two adjacent first conducting wires 12 ranges from 200µm to 2000µm. In some embodiments, the first distance L₅ can be 200µm, 300µm, 500µm, 700µm, 900µm, 1000µm, 1300µm, 1600µm, 1800µm, 1900µm, or 2000µm.

In the above described embodiments, with the current carrier collection ability of the electrode lines ensured, the distribution density of the electrode lines can be within a reasonable range, reducing obstruction of the electrode lines to sunlight irradiation.

In some embodiments, the first conducting wire 12 includes a main section and a widened section, and a size of the widened section along the second direction Y is greater than that of the main section along the second direction Y. In this way, the transferred electrode lines can be electrically connected to bus bars or bus ribbons through the widened section, reducing the difficulty of electrical connection.

It can be understood that a size of the first groove 11a along the second direction Y corresponding to the widened section is greater than that of the first groove 11a along the second direction Y corresponding to the main section.

In some embodiments, the carrier 11 includes a central area and edge areas, and the edge areas are located at opposite sides of the central area along the second direction Y. The first grooves 11a include edge grooves and central grooves. The first conducting wires 12 include edge conducting wires and central conducting wires. The edge grooves and the edge conducting wires therein are distributed in the edge areas. The central grooves and the central conducting wires therein are distributed in the central area.

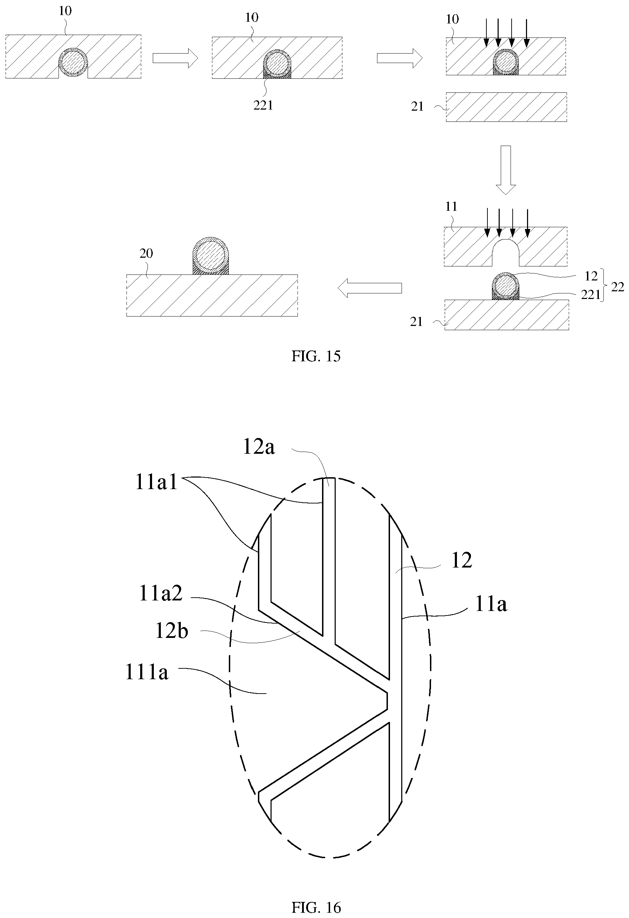

Referring to FIG. 16, in some embodiments, the edge areas include at least one avoidance area 111a, the avoidance area 111a spans across at least two edge grooves and at least two edge conducting wires therein, separating the at least two edge grooves each into at least two sub-grooves 11a1, spaced apart from each other, and separating the at least two edge conducting wires each into at least two sub-wires 12a spaced apart from each other.

The avoidance area 111a is configured for leaving a space for the bus bars or the bus ribbons, reducing the thickness of the bus bars or the bus ribbons at the edges of the cell body 21 and lowering the risk of breakage of the solar cell 20.

In some embodiments, the length of the first groove 11a is equal to the length of the first conducting wire 12 therein.

In some embodiments, the transfer printing assembly 10 further includes a connection conducting wire 12b, and the first surface 111 of the carrier 11 also has a connection groove 11a2. The connection conducting wire 12b is at least partially disposed within the connection groove 11a2. The connection groove 11a2 and the connection conducting wire 12b therein extend along an edge of the avoidance area 111a. The connection groove 11a2 is in communication with same sided sub-grooves 11a1 of the at least two edge grooves, and the connection conducting wire 12b is connected to same sided sub-wires 12a of the at least two edge conducting wires. The connection conducting wire 12b and a wall of the connection groove 11a2 define a connection receiving cavity at a side of the connection conducting wire 12b adjacent to an opening of the connection groove 11a2. The connection receiving cavity is configured to accommodate the slurry material. The connection conducting wire 12b is detachable from the connection groove 11a2 under an action of external energy. In some embodiments, the connection groove and the connection conducting wire therein can further extend to reach an adjacent central groove with a central conducting wire therein. In this way, the sub-wires of the edge conducting wires can be electrically connected to an adjacent first conducting wire 12, e.g., an adjacent central conducting wire, through the connection conducting wire 12b.

Referring to FIG. 1, in some embodiments, the first conducting wire 12 includes an electrically conductive core 121 and an anti-oxidation layer 122 surrounding the core 121, and the material of the anti-oxidation layer 122 includes metal. The oxidation resistance of the anti-oxidation layer 122 is greater than that of the electrically conductive core 121. By coating the anti-oxidation layer 122 around the electrically conductive core 121, the electrically conductive core 121 can be prevented from being oxidized, thereby ensuring the electrical conductivity thereof. The oxidation resistance can be characterized by the rate of oxidation; a higher rate indicates a weaker resistance, and a lower rate indicates a stronger resistance.

In some embodiments, the material of the electrically conductive core 121 includes copper or aluminum. In this way, the electrical conductivity of the first conducting wire 12 can be enhanced while the costs can be reduced.

In some embodiments, the electrically conductive core 121 is a copper or aluminum wire.

In other embodiments, the electrically conductive core 121 includes electrically conductive particles, and adjacent conductive particles are in contact with each other. The conductive particles can be at least one of copper particles or aluminum particles.

Furthermore, gaps exist between adjacent conductive particles, and the gaps are filled with an organic material.

In some embodiments, the material of the oxidation-resistant layer 122 includes at least one of silver, tin, lead, titanium, or nickel.

In some other embodiments, the first conducting wire 12 as a whole can be a copper or aluminum wire. Alternatively, the first conducting wire 12 can be made of electrically conductive particles arranged in the first groove 11a, wherein adjacent conductive particles are in contact with each other, and gaps between adjacent conductive particles are filled with an organic material.

Referring to FIGs. 4 and 5, the cross-section of the first conducting wire 12 can have a round or triangular shape, or can have any other shape such as a trapezoidal, rectangular, or square shape.

In some embodiments, the carrier 11 is a flexible member. For example, the carrier 11 can be made of a heat-resistant polymer.

The transfer printing assembly 10 including the flexible carrier 11 can be easily rolled and stored, facilitating the transportation and storage of the transfer printing assembly 10. In addition, during the transfer printing, the carrier 11 can deform when heated, allowing air to enter more easily between the first conducting wire 12 and the wall of the first groove 11a. The air generates a thrust when heated, making it easier for the first conducting wire 12 to be detached from the first groove 11a.

Alternatively, the carrier 11 can be a rigid member. The present application does not limit the material of the carrier 11.

In some embodiments, the carrier 11 can be made of a transparent material, thus allowing a broader range of wavelength of laser used during the transfer printing. In some other embodiments, the carrier 11 can also be made of a semi-transparent material or an opaque material.

Referring to FIG. 8, in some embodiments, the first surface 111 of the carrier 11 also has a second groove 11c intersecting with the first groove 11a. The transfer printing assembly 10 further includes a second conducting wire 13 intersecting with the first conducting wire 12. The second conducting wire 13 is at least partially disposed within the second groove 11c. The second conducting wire 13 and a wall of the second groove 11c define a second receiving cavity at a side of the second conducting wire 13 adjacent to an opening of the second groove 11c. The second receiving cavity is also configured to accommodate the slurry material. The second conducting wire 13 is detachable from the second groove 11c under an action of external energy.

In some embodiments, the first conducting wires 12 and the slurry material in the first receiving cavities 11b are configured to form finger electrode lines, while the second conducting wires 13 and the slurry material in the second receiving cavities are configured to form busbar electrode lines, i.e., bus bars. The bus bars are adapted to be connected to other solar cells or external circuits through bus ribbons. In the above embodiments, the bus bars and finger electrode lines can be formed simultaneously in the same transfer printing process, thereby reducing the manufacturing costs of the solar cell 20.

The structure of the second conducting wire 13 can be substantially the same as that of the first conducting wire 12, and the structure of the second groove 11c can be substantially the same as that of the first groove 11a, which will not be repeated in herein.

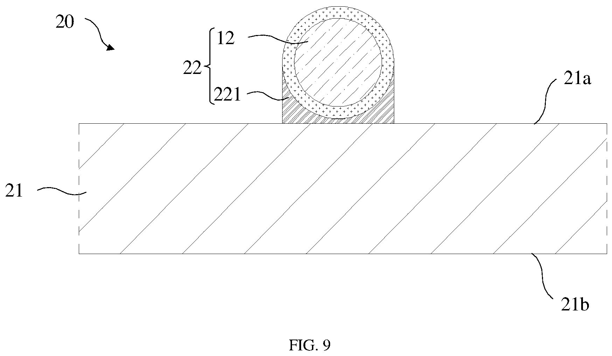

Referring to FIGs. 9-13, a second aspect of the present application provides a solar cell 20. The solar cell 20 can be a heterojunction (HJT) solar cell, a tunnel oxide passivated contact (TOPCon) solar cell, etc. Specifically, the solar cell 20 includes a cell body 21 and a plurality of first electrode lines 22. The cell body 21 includes a first face 21a and a second face 21b opposite to each other. The first electrode lines 22 are disposed on both the first and second faces 21b and spaced apart from each other.

Each first electrode line 22 includes a first metal layer 221 and the first conducting wire 12 which are stacked, and the first metal layer 221 is formed from the slurry material and connected to the cell body 21.

The first conducting wire 12 can be that included in the transfer printing assembly 10 and then transferred onto the cell body 21. The first metal layer 221 can be formed from the slurry material transferred onto the cell body 21 from the first receiving cavity 11b of the transfer printing assembly 10.

The electrode lines of the solar cell 20 provided in embodiments of present application can be formed by using the transfer printing assembly 10. On the one hand, compared with the electroplating method, using the transfer printing assembly 10 to form the electrode lines is conducive to reducing the manufacturing costs. On the other hand, compared with the screen printing method, the width of the electrode lines can be controlled by containing the slurry material in the groove, thereby facilitating formation of the electrode lines with a relatively small width. In addition, by arranging the first conducting wire 12 in the groove, the wastage of the slurry material can be reduced.

Referring to FIG. 9, in some embodiments, an orthogonal projection of the first conducting wire 12 on the cell body 21 falls within an orthogonal projection of the first metal layer 221 on the cell body 21. In an embodiment, the orthogonal projection of the first metal layer 221 on the cell body 21 completely overlaps the orthogonal projection of the first conducting wire 12 on the cell body 21. In another embodiment, the area of the orthogonal projection of the first metal layer 221 on the cell body 21 is larger than the area of the orthogonal projection of the first conducting wire 12 on the cell body 21.

Since the adhesiveness of the first metal layer 221 to the cell body 21 is greater than that of the first conducting wire 12 to the cell body 21, by using the slurry material and having the first metal layer 221 located between the first conducting wire 12 and the cell body 21, the bonding strength between the first electrode line 22 and the cell body 21 can be enhanced.

In some embodiments, on a same side of the cell body 21, two adjacent first electrode lines 22 are spaced apart by a first distance, and the first distance ranges from 200µm to 2000µm. Referring to FIG. 7, L₅ represents the first distance, and the first distance L₅ can be 200µm, 300µm, 500µm, 700µm, 900µm, 1000µm, 1300µm, 1600µm, 1800µm, 1900µm, or 2000µm.

In the above described embodiments, with the current carrier collection ability of the electrode lines 22 ensured, the distribution density of the electrode lines 22 can be within a reasonable range, reducing obstruction of the electrode lines 22 to sunlight irradiation.

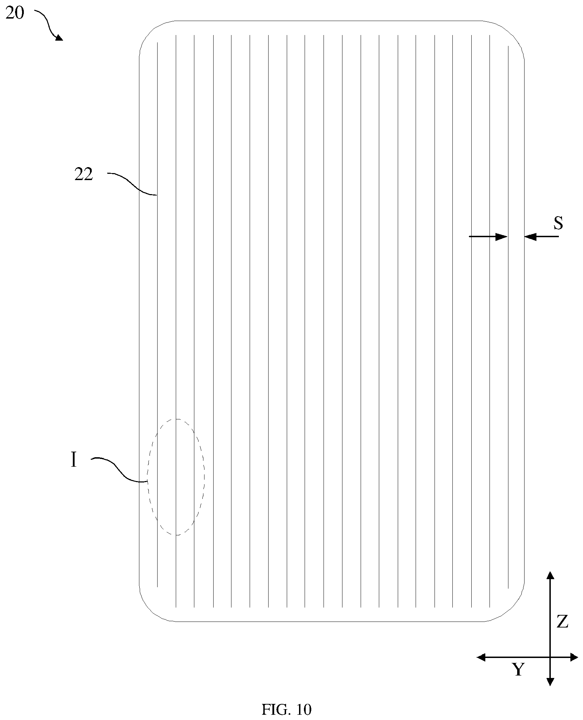

Referring to FIG. 10, in some embodiments, the minimum distance S from the first electrode lines 22 to an edge of the cell body 21 ranges from 50µm to 1500µm. For example, the minimum distance S can be 50µm, 65µm, 75µm, 80µm, 90µm, 100µm, 150µm, 200µm, 300µm, 500µm, 600µm, 800µm, 1000µm, 1200µm, 1400µm, or 1500µm.

By having the minimum distance S within the above ranges, not only the risk of short-circuiting the cell body 21 is minimized but also the layout area of the first electrode lines 22 is optimized, thereby improving the ability of the first electrode lines 22 to collect current carriers.

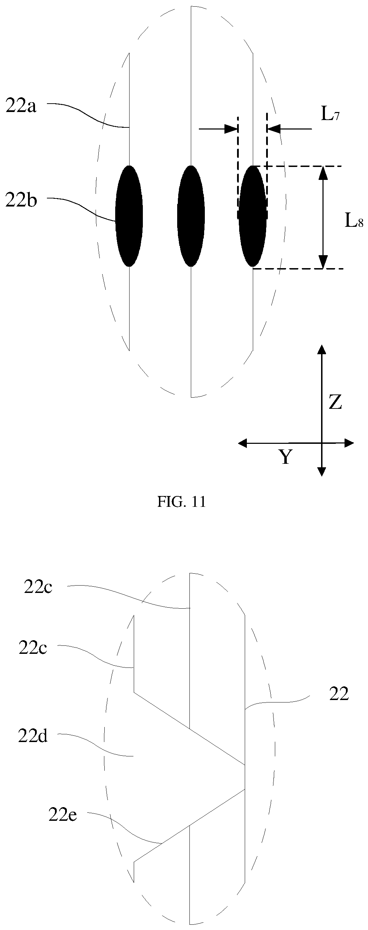

Referring to FIG. 11, in some embodiments, the first electrode lines 22 each include a main portion 22a and a widened portion 22b, and a width of the widened portion 22b is greater than that of the main section 22a.

The widened portion 22b can be a location where the first electrode line 22, such as a finger electrode line, comes into electrical contact with a bus bar or a bus ribbon. The widened portion 22b can make the electrical contact more stable.

In some embodiments, L₇ represents a width of the widened portion 22b, and L₇ ranges from 15µm to 1000µm. For example, L₇ can be 15µm, 100µm, 200µm, 350µm, 500µm, 650µm, 720µm, 840µm, 900µm, 950µm, or 1000µm.

In some embodiments, L₈ represents a length of the widened portion 22b, and L₈ ranges from 100µm and 5000µm. For example, L₈ can be 100µm, 800µm, 1500µm, 2400µm, 3000µm, 3800µm, 4500µm, or 5000µm.

By having L₇ and L₈ within the above ranges, the difficulty of electrical connection of the first electrode line 22 with the bus bar or the bus ribbon can be reduced.

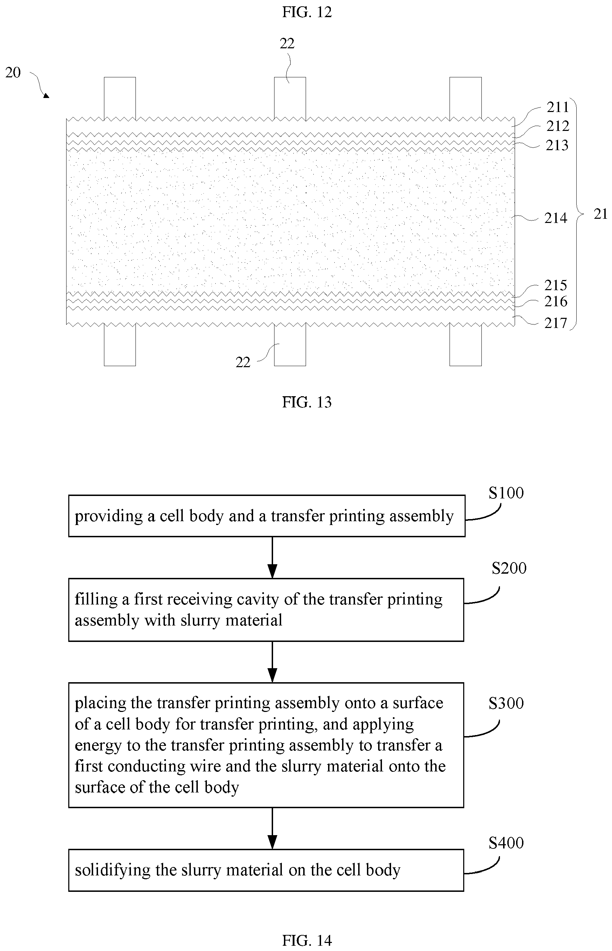

Referring to FIGs. 10 and 12, in some embodiments, the cell body 21 includes a central region and edge regions. The edge regions are located at opposite sides of the central region. The first electrode lines 22 include edge electrode lines and central electrode lines. The edge electrode lines are distributed on the edge regions, and the central electrode lines are distributed on the central region.

In some embodiments, the edge regions include at least one avoidance region 22d. The avoidance region 22d spans across at least two edge electrode lines, separating the at least two edge electrode lines each into at least two sub-electrode lines 22c spaced apart from each other.

The avoidance region 22d is configured for leaving a space for the bus bars or the bus ribbons, reducing the thickness of the bus bars or the bus ribbons at the edges of the cell body 21 and lowering the risk of breakage of the solar cell 20.

In some embodiments, the solar cell 20 further includes a connection electrode line 22e. The connection electrode line 22e is configured to extend along an edge of the avoidance region 22d, and is connected to same sided sub-electrode lines 22c of the two adjacent edge electrode lines. In some embodiments, the connection electrode line 22e can further extend to reach an adjacent central electrode line. In this way, the sub-electrode lines 22c of the edge electrode lines can be electrically connected to an adjacent first electrode line 22, e.g., an adjacent central electrode line, through the connection electrode line 22e.

In some embodiments, the solar cell 20 further includes second electrode lines, the second electrode lines are disposed on at least one of the first face 21a and the second face 21b and electrically connected to the first electrode lines 22. The second electrode lines can be the bus bars. In some embodiments, an orthogonal projection of the second electrode lines on the cell body 21 and an orthogonal projection of the widened portion 22b of the first electrode lines 22 on the cell body 21 have an overlapping area. In other words, the second electrode lines come into contact with the widened portion 22b of the first electrode lines 22. As such, the difficulty of electrical connection of the first electrode lines 22 with the second electrode lines 22 may be reduced. In some other embodiments, a portion of an orthogonal projection of the second electrode lines falls within the avoidance region 22d, which can reduce the thickness of the second electrode lines at the edges of the cell body 21 and lower the risk of breakage of the solar cell 20.

Referring to FIG. 13, in some embodiments, the cell body 21 includes a first transparent conducting layer 211, a first doped layer 212, a first intrinsic semiconductor layer 213, a silicon substrate 214, a second intrinsic semiconductor layer 215, a second doped layer 216, and a second transparent conducting layer 217 stacked in sequence. The first face 21a is located at a side of the first transparent conducting layer 211 away from the silicon substrate 214, and the second face 21b is located at a side of the second transparent conducting layer 217 away from the silicon substrate 214. The electrode lines can be used in a HJT solar cell to reduce the costs of the HJT solar cell.

In some embodiments, the first intrinsic semiconductor layer 213 can be an intrinsic amorphous silicon layer with or without oxygen, and the second intrinsic semiconductor layer 215 can be an intrinsic amorphous silicon layer with or without oxygen.

Referring to FIGs. 14 and 15, a third aspect of the present application provides a method for preparing a solar cell 20, including following steps:
S100: a cell body 21 and a transfer printing assembly 10 as described in any embodiment of the first aspect are provided.
S200: the first receiving cavity 11b of the transfer printing assembly 10 is filled with slurry material. For example, the slurry material is applied to the first surface 111 so that the first receiving cavity 11b is filled with the slurry material.
S300, the transfer printing assembly 10 is placed onto a surface of the cell body 21 for transfer printing, and energy is applied to the transfer printing assembly 10 to transfer the first conducting wire 12 and the slurry material onto the surface of the cell body 21. The surface of the cell body 21 for transfer printing can be a surface of a cell body 21. The energy can be applied onto the region of the first groove 11a by heating or laser irradiation. Under the action of the energy, the first conducting wire 12 and the slurry material can drop onto the surface for transfer printing, thus forming a stable contact with the surface for transfer printing.
S400: the slurry material is solidified on the cell body 21. For example, the cell body 21 can be dried or heated, forming the slurry material into a metal layer, so as to achieve an ohmic contact between the first electrode line 12 and the metal layer with the cell body 21.

The preparation method of the solar cell in embodiments of the present application involves transfer printing to form electrode lines. On the one hand, compared with the electroplating method, using the transfer printing assembly is conducive to reducing the manufacturing costs. On the other hand, compared with the screen printing method, the width of the electrode lines can be controlled by containing the slurry material in the groove, thereby facilitating formation of the electrode lines with a relatively small width. In addition, by arranging the first conducting wire 12 in the groove, the wastage of the slurry material can be reduced.

In addition, it can be understood that electrode lines of a solar cell 20 do not have to be all formed by using the transfer printing assembly 10. In some embodiments, the finger electrode lines are formed by the transfer printing method using the transfer printing assembly 10, and the bus bars are formed by screen printing. In some other embodiments, the finger electrode lines and the bus bars are simultaneously transfer printed by using the transfer printing assembly 10. The method for forming the bus bars is not limited in the present application.

It should be understood that, unless otherwise specified herein, the sequence of the steps is not strictly limited, and the steps may be performed in other orders. Moreover, at least some of the steps may include multiple sub-steps or multiple stages, these sub-steps or stages are not necessarily performed at the same time, but may be performed at different times. These sub-steps or stages are not necessarily to be sequentially performed, but can be performed alternately or in turn with at least some of the sub-steps or stages of other steps.

The technical features of the above embodiments can be combined arbitrarily. In order to make the description concise, not all possible combinations of the technical features are described in the embodiments. However, as long as there is no contradiction in the combination of these technical features, the combinations should be considered as in the scope of the present application.

The above-described embodiments are only several implementations of the present application, and the descriptions are relatively specific and detailed, but they should not be construed as limiting the scope of the present application. It should be understood by those of ordinary skill in the art that various modifications and improvements can be made without departing from the concept of the present application, and all fall within the protection scope of the present application. Therefore, the patent protection of the present application shall be defined by the appended claims.

## Claims

1. A transfer printing assembly, comprising:
a carrier (11) comprising a first surface (111) having a first groove (11a); and
a first conducting wire (12) at least partially disposed within the first groove (11a), the first conducting wire (12) and a wall of the first groove (11a) defining a first receiving cavity (11b) at a side of the first conducting wire (12) adjacent to an opening of the first groove (11a), the first receiving cavity (11b) being configured to accommodate slurry material;
wherein the first conducting wire (12) is detachable from the first groove (11a) under an action of external energy.

2. The transfer printing assembly according to claim 1, wherein an entirety of the first conducting wire (12) is located in the first groove (11a); or
the first conducting wire (12) partially protrudes out from the opening of the first groove (11a), a cross-section of the first conducting wire (12) has an end that is located away from the first groove (11a), and a distance between the end of the cross-section and the opening of the first groove (11a) is greater than 0µm and less than or equal to 200µm.

3. The transfer printing assembly according to claim 1 or 2, wherein the carrier (11) comprises a second surface (112) opposite to the first surface (111);
a peripheral surface of the first conducting wire (12) comprises an inner portion that is adjacent to the second surface (112), and the inner portion is in contact with a portion of the wall of the first groove (11a);
a size of the first conducting wire (12) along a first direction is less than or equal to a size of the first groove (11a) along the first direction, and the first direction is from the first surface (111) to the second surface (112).

4. The transfer printing assembly according to claim 3, wherein the peripheral surface of the first conducting wire (12) comprises an outer portion that is away from the second surface (112), the minimum distance between the outer portion and the opening of the first groove (11a) is in a range from 0 to 200µm; and/or
wherein 0.25L₁≤L₂≤L₁, wherein L₁ is the maximum distance between the outer portion and the opening of the first groove (11a), and L₂ is the minimum distance between the outer portion and the opening of the first groove (11a).

5. The transfer printing assembly according to claim 3, wherein a size of the opening of the first groove (11a) along a second direction is greater than or equal to a size of the first conducting wire (12) along the second direction, and the second direction is perpendicular to the first direction;
preferably, the size of the first conducting wire (12) along the first direction ranges from 1µm to 220µm; and/or
preferably, the size of the first conducting wire (12) along the second direction ranges from 5µm to 220µm.

6. The transfer printing assembly according to any one of claims 1 to 5, wherein the first surface (111) of the carrier (11) has a plurality of first grooves (11a) spaced apart along the second direction, and the transfer printing assembly comprises a plurality of first conducting wires (12) spaced apart along the second direction; the plurality of first grooves (11a) and the plurality of first conducting wires (12) all extend along a third direction; the plurality of first conducting wires (12) are at least partially disposed within the plurality of first grooves (11a) in a one-to-one correspondence;
preferably, a first distance between any two adjacent first conducting wires (12) ranges from 200µm to 2000µm.

7. The transfer printing assembly according to claim 6, wherein the first conducting wire (12) comprises a main section and a widened section, and a size of the widened section along the second direction is greater than a size of the main section along the second direction.

8. The transfer printing assembly according to claim 6, wherein the carrier (11) comprises a central area and edge areas, and the edge areas are located at opposite sides of the central area along the second direction;
the plurality of first grooves (11a) comprise edge grooves and central grooves, the plurality of first conducting wires (12) comprise edge conducting wires and central conducting wires; the edge grooves and the edge conducting wires therein are distributed in the edge areas, and the central grooves and the central conducting wires therein are distributed in the central area; and
the edge areas comprise an avoidance area (111a), the avoidance area (111a) spans across at least two edge grooves and at least two edge conducting wires therein, separating the at least two edge grooves each into at least two sub-grooves (11a1) spaced apart from each other, and separating the at least two edge conducting wires each into at least two sub-wires (12a) spaced apart from each other;
preferably, the transfer printing assembly further comprises a connection conducting wire (12b), wherein the first surface (111) of the carrier (11) also has a connection groove (11a2), the connection conducting wire (12b) is at least partially disposed within the connection groove (11a2);
the connection groove (11a2) and the connection conducting wire (12b) therein extend along an edge of the avoidance area (111a); the connection groove (11a2) is in communication with same sided sub-grooves (11a1) of the at least two edge grooves, and the connection conducting wire (12b) is connected to same sided sub-wires (12a) of the at least two edge conducting wires; and
the connection conducting wire (12b) and a wall of the connection groove (11a2) define a connection receiving cavity at a side of the connection conducting wire (12b) adjacent to an opening of the connection groove (11a2); the connection receiving cavity is configured to accommodate the slurry material; the connection conducting wire (12b) is detachable from the connection groove (11a2) under an action of external energy.

9. The transfer printing assembly according to any one of claims 1 to 8, wherein the first conducting wire (12) comprises an electrically conductive core (121) and an anti-oxidation layer (122) surrounding the core, and a material of the anti-oxidation layer (122) comprises metal;
preferably, a material of the conductive core comprises copper or aluminum; and/or
preferably, a material of the anti-oxidation layer (122) comprises at least one of silver, tin, lead, titanium, or nickel.

10. The transfer printing assembly according to any one of claims 1 to 9, wherein the carrier (11) is a flexible member.

11. The transfer printing assembly according to any one of claims 1 to 10, wherein the first surface (111) of the carrier (11) also has a second groove (11c) intersecting with the first groove (11a);
the transfer printing assembly further comprises a second conducting wire (13) intersecting with the first conducting wire (12); the second conducting wire (13) is at least partially disposed within the second groove (11c); the second conducting wire (13) and a wall of the second groove (11c) define a second receiving cavity at a side of the second conducting wire (13) adjacent to an opening of the second groove (11c); the second receiving cavity is configured to accommodate the slurry material;
the second conducting wire (13) is detachable from the second groove (11c) under an action of external energy.

12. A method for preparing a solar cell, comprising:
providing a cell body (21) and a transfer printing assembly (10) of any one of claims 1 to 11;
filling the first receiving cavity (11b) of the transfer printing assembly (10) with slurry material;
placing the transfer printing assembly (10) onto a surface of the cell body (21) for transfer printing, and applying energy to the transfer printing assembly (10) to transfer the first conducting wire (12) and the slurry material onto the surface of the cell body (21); and
solidifying the slurry material on the cell body (21).

13. A solar cell comprising:
a cell body (21) comprising a first face (21a) and a second face (21b) opposite to each other; and
first electrode lines (22) disposed on both the first and second faces (21a, 21b) and spaced apart from each other;
wherein each first electrode line (22) comprises a first metal layer (221) and a first conducting wire (12) stacked on the first metal layer (221), and the first metal layer (221) is connected to the cell body (21).

14. The solar cell according to claim 13, wherein an orthogonal projection of the first conducting wire (12) on the cell body (21) falls within an orthogonal projection of the first metal layer (221) on the cell body (21).

15. The solar cell according to claim 13 or 14, wherein on a same side of the cell body (21), two adjacent first electrode lines (22) are spaced apart by a first distance, and the first distance ranges from 200µm to 2000µm; and/or
wherein the minimum distance from the first electrode lines (22) to an edge of the cell body (21) ranges from 50µm to 1500µm.
